# FASCICULE DE BREVET EUROPEEN

(11) **EP 0 753 827 B1**
(45) Date de publication et mention de la délivrance du brevet: **16.01.2002**
(21) Numéro de dépôt: 96201903.0
(22) Date de dépôt: 04.07.1996
(51) Int. Cl.: G06K 19/077

(54) **Procédé de production et d'assemblage de carte à circuit intégré et carte ainsi obtenue**
Anfertigungs- und Zusammenstellungsverfahren einer Chipkarte und nach diesem Verfahren hergestellte Karte
Method of producing and assembling chip cards and card obtained by this method

(30) Priorité: 11.07.1995 FR 9508369
(43) Date de publication de la demande: 15.01.1997
(73) Titulaire: OBERTHUR CARD SYSTEMS SA, 75017 Paris (FR)
(72) Inventeur: Launay, François, 75008 Paris (FR); Venambre, Jacques, 75008 Paris (FR); Severin, Jan, 75008 Paris (FR); van Noort, Harry, 75008 Paris (FR)
(74) Mandataire: Barbin le Bourhis, Joel

(56) Documents cités:
- EP-A- 0 180 101
- EP-A- 0 424 530
- EP-A- 0 592 938
- EP-A- 0 688 051
- FR-A- 2 684 471
- GB-A- 2 202 675
- US-A- 4 870 751
- US-A- 5 081 520

## Description

La présente invention concerne un procédé de production et d'assemblage de carte électronique comportant un support de carte électriquement isolant muni d'un logement pour recevoir un circuit intégré et, sur une face, des plages métalliques de contact reliées électriquement aux contacts dudit circuit intégré, comportant les étapes suivantes :
- une première étape d'application, par une technologie MID (Moulded Interconnection Devices en anglais), de pistes électriquement conductrices, toutes disposées contre le fond et les parois latérales dudit logement et reliées, chacune, à l'une desdites plages métalliques de contact disposées sur la face du support qui comporte ledit logement,
- une deuxième étape de mise en place par collage au fond du logement dudit circuit intégré par sa face qui ne comporte pas les contacts,
- une troisième étape de réalisation des connexions électriques par soudure de fils conducteurs entre les contacts du circuit intégré et les extrémités des pistes conductrices correspondantes,
- une quatrième étape de remplissage dudit logement avec une résine de protection qui est ensuite polymérisée.

L'invention concerne aussi la carte électronique obtenue par ce procédé.

Le circuit intégré (ou puce), inséré dans le logement du support peut être une mémoire électronique, ou un microprocesseur, de surface plus grande que la simple mémoire.

Une technologie couramment utilisée pour la réalisation de cartes à puce, citée ici au titre de l'arrière plan technologique, consiste à utiliser un circuit imprimé déposé sur un film support, généralement en verre époxy, en polyimide ou en polyester, comme décrit par exemple dans le brevet européen EP 0 201 952 B1 au nom de la demanderesse (PHF 85/533). Il est aussi connu d'utiliser une grille surmoulée. Le film support ou la grille portent sur l'une des faces les plages métalliques de contact externe de la carte ; l'autre face sert de support à la puce électronique qui est reliée électriquement aux contacts externes, à travers le film, ou la grille. Le matériau du film support et le matériau utilisé pour le surmoulage des grilles sont isolants afin d'isoler électriquement les contacts externes et les connexions internes de la puce électronique.

L'assemblage de la carte à puce consiste alors à :
- coller le circuit intégré (la puce) sur la face interne du film ou de la grille,
- réaliser les connexions électriques reliant les contacts de la puce aux plages métalliques de contacts externes (au moyen de fils conducteurs),
- protéger la puce et les connexions au moyen d'une résine de protection,
- découper le module électronique ainsi formé pour le détacher du film support ou de la grille,
- insérer et coller le module dans un support de carte en matière plastique (généralement du PVC, de l'ABS ou du polycarbonate) dans laquelle a été préalablement réalisé un logement (cavité) pour recevoir ledit module par son côté qui supporte le circuit intégré (la puce). Ce logement peut être réalisé par moulage par injection ou par lamage.

Ces technologies présentent plusieurs inconvénients :
- l'opération de protection de la puce est délicate car l'épaisseur de la résine doit être soigneusement contrôlée et limitée.
- l'insertion du module électronique dans la carte exige des tolérances de planéité et de positionnement très serrées, et son collage doit être très efficace pour satisfaire les tests de torsion et de flexion imposés.

Pour s'affranchir de ces inconvénients, la demanderesse préfère utiliser la technologie indiquée au premier paragraphe et décrite dans la demande de brevet européen n° 0 688 051 ayant pour titre : "Procédé de fabrication et d'assemblage de carte à circuit intégré et carte ainsi obtenue". Pour la présente demande, ce document ne fait partie de l'état de la technique qu'au titre de l'article 54(3) et (4) de la CBE. Avec cette nouvelle technologie, un film ou une grille supportant sur une face les plages métalliques de contact n'est plus nécessaire et seuls demeurent les deux éléments que sont le support de carte et le circuit intégré. Outre la suppression de ce module intermédiaire, le nombre d'étapes de procédé pour la fabrication et l'assemblage d'une carte à circuit intégré est réduit et l'on s'affranchit des contraintes de positionnement mécanique des plages métalliques de contact externe sur la carte. Encore un avantage de cette nouvelle technique est qu'elle permet de régler l'enfoncement du circuit dans l'épaisseur de la carte et que la position moyenne des contacts est plus rapprochée de la fibre neutre, à mi-épaisseur du support, que dans la technologie courante avec module, ce qui est favorable pour bien résister aux efforts de flexion et de torsion de la carte.

Une autre différence entre les deux technologies est que le circuit intégré occupe des positions renversées, par rapport à l'ensemble de la carte électronique, selon qu'on utilise l'une ou l'autre de ces technologies. Pour pouvoir mettre en oeuvre simplement la nouvelle technologie indiquée au premier paragraphe, il faut alors utiliser un circuit intégré qui lui est spécialement adapté, c'est-à-dire un circuit symétrique par rapport à un plan d'un circuit normalement disponible sur le marché qui est compatible avec les technologies classiques et largement répandues utilisant un module. Le problème technique que se propose de résoudre l'invention est précisément d'adapter ladite nouvelle technologie aux circuit intégrés normalement disponibles dans le commerce pour une utilisation dans une carte électronique habituelle avec module.

Ce but est atteint, selon un premier mode de réalisation préféré de l'invention grâce au procédé de la revendication 1.

Ce mode de réalisation convient lorsque sont utilisés des circuits intégrés dont les contacts (y compris le contact de masse) sont ramenés d'un même côté du composant. Ainsi, il n'y a pas de risque de court-circuit entre pistes, sous le circuit intégré, dans la zone d'encollage de ce dernier.

Selon ce premier mode de réalisation, il peut arriver que dans la zone où les pistes sont intercalées, une définition meilleure que dans les autres zones s'avère nécessaire ; il est alors avantageux d'introduire, entre la première et la deuxième étape, une étape supplémentaire consistant à compléter la configuration des pistes, au moins dans cette zone centrale du fond du logement, par une opération de gravure par faisceau laser, fixe ou mobile.

Un deuxième mode de réalisation de l'invention est le procédé défini à la revendication 3.

Pour la mise en oeuvre de ce deuxième mode de réalisation, il est avantageux que le support de carte comporte un logement à deux niveaux de profondeur, à savoir un palier périphérique à niveau intermédiaire qui comporte les extrémités des pistes conductrices et un niveau central, plus profond, sur lequel est collé le circuit intégré. On diminue ainsi le risque qu'un conducteur ne touche le bord supérieur du circuit intégré, lors de la troisième étape de soudure des fils de connexion, ce qui serait un défaut électrique inacceptable.

Avantageusement, la première étape d'application des pistes électriquement conductrices consiste en la découpe et le collage par pression à chaud des pistes munies d'une colle activable à chaud (hot foil embossing en anglais).

La description qui suit, en regard des dessins annexés, le tout donné à titre d'exemple non limitatif, fera bien comprendre comment l'invention peut être réalisée.

La figure 1 représente en coupe avec arrachement une carte électronique de l'art antérieur avec module.

La figure 2 représente en coupe avec arrachement et la figure 3 en plan avec arrachement, une carte électronique de l'art antérieur utilisant la nouvelle technologie sans module.

Les figures 4 et 5 montrent un premier mode de réalisation de l'invention, la figure 4 selon une vue en plan, avec arrachement et la figure 5 en coupe avec arrachement.

La figure 6 représente, vue en plan avec arrachement, une variante du premier mode de réallisation de l'invention.

Les figures 7 et 8 montrent, avec le même mode de représentation que pour les figures 4 et 5 respectivement, un deuxième mode de réalisation de l'invention.

Sur les différentes figures, les mêmes références représentent les mêmes éléments avec les mêmes fonctions.

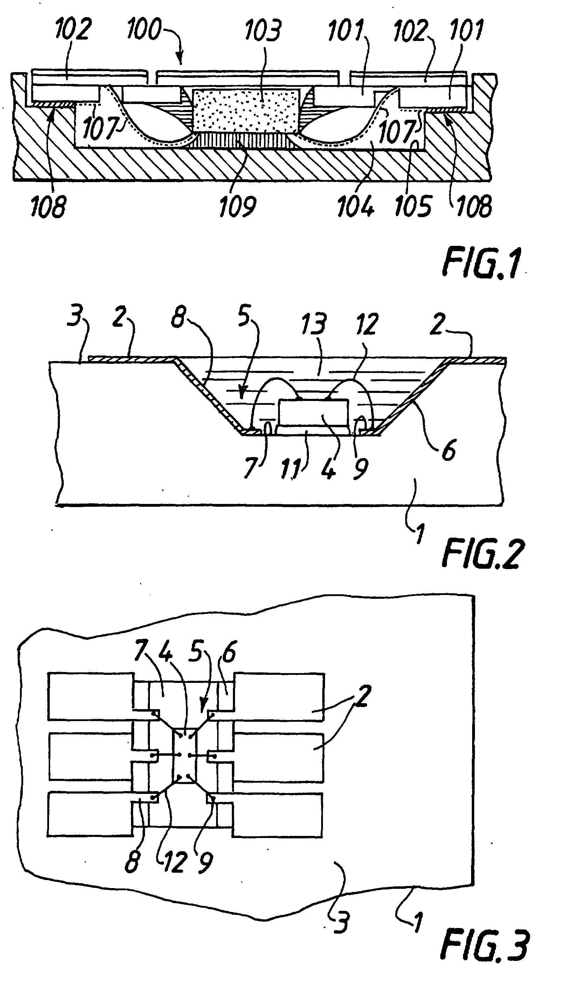

Selon la figure 1, une carte électronique comporte un module 100, présentant un film support de circuit (101, 102) et un circuit intégré 103, fixé dans un logement 104, le circuit intégré 103 étant disposé contre une face inférieure du film support (101, 102) de telle sorte que le circuit intégré est disposé à l'intérieur du logement 104 et ses contacts font face au fond 105 du logement 104. Le circuit 103 est collé de manière classique sur le film support (101, 102), et des fils de connexion 107 sont soudés entre les contacts du circuit intégré 103 et le film support (101, 102), lequel présente des couches conductrices qui constituent des plages métalliques de contact destinées à coopérer avec un lecteur de carte. Le film support présente ici une couche conductrice 102 en l'espèce une feuille de cuivre sur laquelle ont été déposées électrolytiquement une couche de Ni, puis une couche d'Au et une couche isolante 101, l'ensemble formant un support souple. On trouvera une description plus détaillée sur l'élaboration du module 100 dans la demande de brevet français FR 2 580 416 déposée le 12/04/1985.

Le module 100, obtenu après découpe est retourné et collé en 108 dans le logement 104. En 108, un adhésif double face pelable peut être mise en oeuvre selon la demande de brevet FR 2 580 416 précitée, la couche pelable pouvant servir de masque à un vernis de protection. Enfin, un collage en 109 est réalisé par une couche de résine de polyuréthane, relativement dure, de manière à obtenir une bonne rigidité mécanique de l'ensemble.

Une nouvelle technologie d'assemblage permet de s'affranchir du stade intermédiaire de la confection du module, comme représenté aux figures 2 et 3 qui montrent les parties actives d'une carte électronique, où se trouvent les plages métalliques de contact destinées à coopérer avec les palpeurs d'un lecteur de carte. Le support de carte 1 comporte ces plages 2, de dimensions et de positionnement normalisés, sur une face 3 (dite supérieure) de la carte. Les plages métalliques sont, au moins pour certaines, reliées électriquement aux contacts d'un circuit intégré (ou puce) 4 qui est compris dans l'épaisseur du corps, ou support de carte 1.

Pour la mise en oeuvre du procédé indiqué au premier paragraphe, le support 1 comporte un logement 5 avec des parois latérales de préférence inclinées selon un angle de 45° environ, telles que 6, et dont le fond 7 est destiné à recevoir la puce de circuit intégré 4, et des pistes conductrices 8 (dites aussi lignes de métallisation) qui forment une continuité avec les plages 2, s'étendent de la face 3 du corps de carte, jusqu'au fond 7 du logement où se trouve leur extrémité libre 9 en passant sur les parois latérales du logement 5 qu'elles traversent. Le logement 5 doit avoir une profondeur inférieure à 600 µm afin de laisser une épaisseur de plastique suffisante en fond de carte pour éviter une cassure dudit fond de carte et protéger la puce électronique. Divers procédés peuvent être utilisés pour solidariser les pistes 8, essentiellement en cuivre, au support 1 qui est réalisé, avec son logement 5, de préférence par moulage par injection d'une matière thermoplastique telle que de l'ABS, ou du polycarbonate. Certains de ces procédés, préférés, sont décrits plus loin. Un choix est aussi possible entre plusieurs procédés pour la réalisation des connexions électriques reliant les contacts du circuit intégré mis en place dans le logement auxdites pistes conductrices au fond du logement. Celui, classique, représenté à la figure 2, consiste à monter le circuit intégré 4, collé par sa base au moyen d'une couche de colle polymérisable 11, généralement une colle époxy, au fond du logement 5, puis à souder des fils conducteurs 12, par exemple en or ou en aluminium, entre les contacts du circuit intégré 4 et les extrémités 9 des pistes conductrices. Divers procédés de montage et de câblage du circuit intégré sont bien conus de l'homme du métier et décrits dans de nombreuses publications, parmi lesquelles on peut citer les brevets FR 2 439 438, FR 2 548 857, EP 0 116 148, FR 2 520 541. Pour un tel montage, lorsque la base du circuit intégré constitue la masse, il est prévu qu'une extrémité de piste occupe la partie centrale du fond du logement (non représenté à la figure 2) et que cette base métallisée y soit collée au moyen d'une colle conductrice, par exemple une colle chargée à l'argent à raison de 70 % en volume. L'opération de collage peut être effectuée avec les colles et les équipements standards utilisés dans l'industrie des semiconducteurs (types KS, ESSEC ou autres). Le montage représenté à la figure 2 est celui pour lequel le circuit intégré possède tous ses contacts, y compris la masse sur une même face (la face supérieure à la figure 2).

Pour ce qui est du câblage par soudure de fils conducteurs, des fils d'or ou d'aluminium peuvent être utilisés, quoique le fil d'or soit préféré pour des questions de rapidité (le procédé thermosonique utilisé pour la soudure des fils d'or est 3 à 4 fois plus rapide que la soudure des fils d'aluminium). Cette opération est la plus délicate du procédé d'assemblage car elle nécessite un préchauffage du support plastique. Comme il n'est pas souhaitable que ce préchauffage excède la température de transition vitreuse Tg du support plastique (risque de déformation), il est préférable d'utiliser des cartes réalisées dans des matériaux à fort Tg (polycarbonate, ABS, composés ABS-PVC, ou composés ABS-polycarbonate).

Après montage et collage de la puce, l'opération de remplissage de la cavité 5 peut être réalisée par un procédé simple dit de potting en anglais et qui consiste en le dépôt d'une goutte de résine 13 dans la cavité 5. Afin d'obtenir une surface externe plane, on utilise de préférence des résines à très faible viscosité, telle par exemple la résine référencée 931-1 de la société américaine ABLESTICK. Cette résine doit posséder une haute pureté ionique et présenter une bonne résistance à l'absorption d'eau afin de protéger la puce électronique de façon efficace au cours des tests climatiques. Après application dans la cavité, la résine est polymérisée, ce qui constitue la dernière étape du procédé de fabrication et d'assemblage de la carte électronique n'utilisant pas de module intermédiaire.

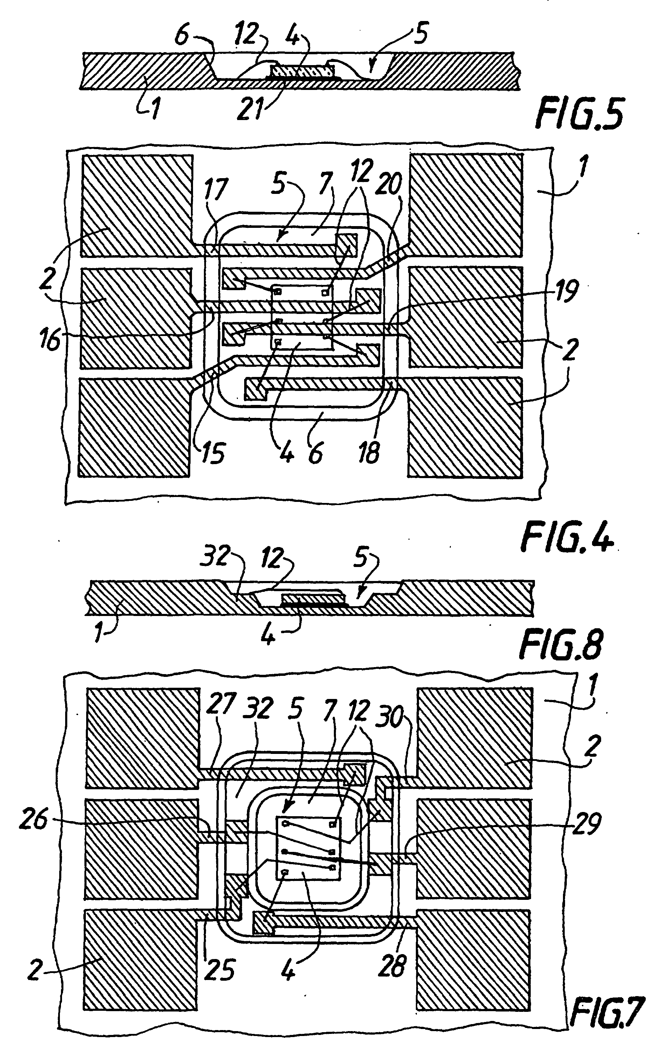

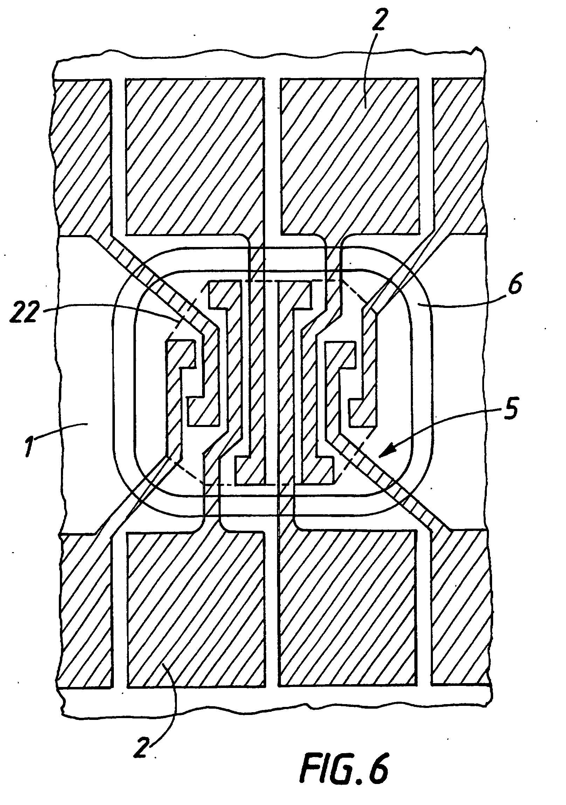

En comparant les figures 1 et 2, on peut noter que le circuit intégré 4, figure 2, occupe une position retournée, de 180° par rapport à celle du circuit intégré 103 de la figure 1. En effet, au lieu que les contacts du circuit intégré et les plages métalliques soient dans des directions opposées, à la figure 1, ils font face à la même direction, c'est-à-dire qu'ils sont tournés vers le haut à la figure 2. Etant donné que chaque plage métallique est conçue et normalisée pour être connectée à tel contact particulier du circuit intégré, en vue de la coopération de la carte avec un lecteur, on en déduit que les circuits intégrés 103 (figure 1) et 4, (figure 2 et 3), même s'ils présentent la même structure de base et les mêmes fonctions, ne sont pas identiques en ce sens qu'il y a entre eux une permutation (une interversion) entre leurs contacts droits et gauches. Or, l'invention se propose de mettre en oeuvre la technologie décrite en référence aux figures 2 et 3 tout en utilisant un composant de grande série tel que 103, figure 1. Pour cela, une solution consiste à intercaler les pistes conductrices au fond de la cavité (du logement) 5, comme représenté aux figures 4 et 5, en ramenant de la gauche vers la droite du fond du logement 5 les extrémités des pistes 15, 16 et 17, et réciproquement, pour ce qui est des pistes 18, 19 et 20. On compense ainsi l'interversion des contacts précitée qu'il aurait sinon fallu opérer sur le circuit imprimé pour pouvoir appliquer directement la technologie des figures 2 et 3. Une telle opération s'accompagne cependant de deux particularités :

En premier lieu on notera que, pour sa fixation contre le support de carte, il est nécessaire de coller le circuit intégré partiellement sur des pistes métalliques, contrairement au cas des figures 2 et 3. Pour le mode de réalisation des figures 4 et 5, il est donc nécessaire d'utiliser un circuit intégré dont tous les contacts sont ramenés du même côté. De plus, la colle utilisée ne doit pas occasionner de courts-circuits entre pistes ni entre piste et circuit intégré. Une colle isolante qui convient pour la fixation du circuit intégré, référencée 21 à la figure 5, est une colle de type Epoxy par exemple du type D125F fournie par la société GRACE (anciennement Emerson & Cuming, ou encore la colle isolante ABLESTICK 931-1 qui polymérise en 6 mn à 120°C, et qui est produite par la société américaine ABLESTICK, appartenant à la société National Starch and Chemical, 20021 Susana Road, Rancho Dominguez, CA 90021.

Une deuxième particularité du premier mode de réalisation de l'invention des figures 4 et 5 est que, du fait que les pistes s'intercalent au fond du logement 5, il peut se faire qu'une résolution fine, pour les pistes, soit requise. Dans l'exemple de la figure 4, où 6 pistes seulement sont intercalées, une technologie MID (Moulded Interconnexion Devices) procurant une résolution de 250 µm entre pistes est suffisante. A cet effet, on préfère la technique d'emboutissage à chaud, c'est-à-dire de découpe et de collage par pression à chaud des pistes munies d'une colle activable à chaud (hot foil embossing en anglais). On peut aussi appliquer par tampographie un catalyseur selon la configuration désirée pour les pistes sur le support de carte, puis réaliser une métallisation aux endroits désirés par autocatalyse.

Il peut se faire cependant qu'une résolution plus fine, par exemple de 100 µm entre pistes soit nécessaire, notamment dans le cas où 8 pistes se côtoient, comme représenté à la figure 6. Dans un tel cas la première étape d'application des pistes peut se décomposer en deux sous-étapes : une première sous-étape comme décrit au paragraphe précédent aux endroits où une définition fine n'est pas requise et qui laisse métallisée la plus grande partie du fond du logement 5, par exemple la partie située à l'intérieur de la ligne fermée 22 en trait interrompu, figure 6, cette ligne étant virtuelle, pour les besoins de l'explication ; puis une deuxième sous-étape (ou étape supplémentaire) consistant à compléter la configuration des pistes, au moins dans la zone où elles s'intercalent, au fond du logement, par une opération de gravure par faisceau laser, fixe ou mobile. Un faisceau mobile peut être obtenu au moyen d'un laser YAG, à rayonnement infrarouge, qui permet une vitesse d'ablation de 3 m/s. On peut aussi utiliser un laser émettant un rayonnement ultraviolet à pompage optique du type krypton-fluor qui projette, au moyen d'une optique adaptée, et de façon statique, l'image de la structuration de pistes à réaliser sur le fond du logement 5. Ce dernier laser peut enlever, sur toute la surface à traiter, 1 µm d'épaisseur de métal par impulsion.

Le deuxième mode de réalisation de l'invention représenté aux figures 7 et 8 peut se satisfaire quant à lui d'un circuit intégré qui présenterait un plan de masse sur une face et les autres contacts sur la face opposée ou bien, comme représenté aux figures 7 et 8 d'un circuit intégré dont tous les contacts sont situés d'un seul et même côté.

A la figure 7, le circuit intégré 4 occupe la même position, centrale et parallèle aux autres structures, qu'à la figure 4, et les pistes 25, 26, 27, situées à gauche sur la figure ne sont pas intercalées avec les pistes de droite 28, 29 et 30. Par contre, trois différences distinguent cette technologie de la technologie connue de la figure 3, les deux premières étant nécessaires et la troisième optionnelle. On notera qu'à la figure 7, au titre d'une première différence, les extrémités des pistes situées en vis-à-vis de part et d'autre du fond du logement sont décalées en direction de deux coins diamétralement opposés du fond du logement, de sorte que les extrémités de pistes n'occupent plus une symétrie axiale, comme sur la figure 3 mais plutôt une symétrie par rapport au centre du logement. Une deuxième différence est que les connexions électriques s'étendent et s'intercalent au-dessus de la face du circuit intégré 4 qui porte les contacts. La soudure des fils conducteurs ainsi réalisée est assez délicate parce que le pas entre conducteurs adjacents est réduit par rapport à ce qu'il est à la figure 3 ; il peut être nécessaire de couder le fil, parallèlement au plan de la carte et aussi l'on préfère, en général, éviter que le conducteur n'enjambe le circuit intégré, comme sur la figure 7 car cela risque de provoquer un contact entre le conducteur et le bord du circuit intégré, contact parasite qui doit être absolument évité. Pour réduire ce dernier risque de faux contact, il est avantageux que le logement, dans le corps de carte, comporte un palier intermédiaire 32, figures 7 et 8, agencé pour que, lors de la première étape du procédé, les extrémités des pistes conductrices soient disposées sur ce palier intermédiaire qui entoure le circuit intégré lors de la troisième étape au cours de laquelle les contacts du circuit intégré et les extrémités des pistes conductrices se retrouvent sensiblement au même niveau, à mi profondeur du logement 5, comme cela apparaît clairement à la figure 8. Cette dernière particularité de la carte de la figure 7 constitue la troisième différence, optionnelle mais préférée entre les figures 3 et 7.

Plusieurs techniques connues sont à la disposition de l'homme du métier pour la réalisation des différentes étapes du procédé. On s'attache simplement à indiquer ci-après quelles sont les techniques préférées.

Le support 1 est réalisé, avec son logement 5, de préférence par moulage par injection d'une matière thermoplastique telle que l'ABS ou, de préférence, du polycarbonate (PC) qui tient mieux en température. Comme polycarbonate, on peut choisir du LEXAN HF 1110 R produit par la société General Electric. On peut aussi utiliser des composés ABS-PC, tel le CYCOLLOY C 1100 HF de General Electric, ou des polyesters haute température, comme par exemple l'Eastalloy DAOO3 de la société américaine Eastman Chemicals. Il faut noter que les températures nécessaires pour l'estampage à chaud et la soudure fil peuvent excéder largement 100°C et rester compatibles avec les supports plastiques utilisés, dans la mesure où le temps passé réellement à la température de pointe n'excède pas quelques secondes.

Pour la première étape du procédé, le procédé MID préféré est celui d'emboutissage (ou encore d'estampage) à chaud d'une configuration de pistes collables, dit Hot Foil Embossing en anglais. Sur ce sujet, on peut citer par exemple le contenu du brevet EP 0 063 347. Avec un cycle thermique d'une durée de l'ordre de 2 s, une configuration de pistes métalliques de 12 à 70 µm d'épaisseur peut être appliquée contre le support de carte, à l'endroit du logement 5 dont la forme est conçue à cet effet, c'est-à-dire avec parois inclinées de préférence, de 45 degrés environ, la pression d'application étant de l'ordre de 80 N/mm² et la température de l'ordre de 200°C. A cet effet, les feuilles d'estampage à chaud qui comportent les configurations de pistes ont une structure multi-couches : une ou plusieurs couches de colle réactivable à chaud (généralement à base de phénols) ayant une épaisseur de 1 à 4 µm, une couche de cuivre, assez ductile, d'épaisseur comprise entre 12 et 35 µm, et éventuellement une couche d'étain ou de nickel de quelques µm d'épaisseur. La partie de la feuille qui n'est pas estampée peut ensuite être otée à partir d'une station d'enroulement avec du ruban adhésif.

Pour obtenir une bonne ductibilité du cuivre on peut, si le support est en polycarbonate, opérer un recuit à 140°C pendant 30 mn. Par contre, un support en ABS, plus sensible à la température, ne supporterait pas cette opération, et il faut alors utiliser avant même l'application des pistes, du cuivre qui est déjà ductile. L'emboutissage à chaud des pistes conductrices s'intègre bien à une chaîne d'assemblage de carte électronique.

Pour la première étape, on peut aussi utiliser un procédé de tampographie, suivi d'une métallisation par autocatalyse. Par le procédé de tampographie, avec une durée de cycle de 2 s, une laque contenant du palladium peut être imprimée contre le support de carte 1, contre les parois et le fond du logement 5 et autour de ce dernier sur la face 3, selon le dessin requis pour la configuration des pistes métalliques à créer à cet endroit. La qualité de l'impression est bonne, puisqu'il est ainsi possible d'obtenir une précision de l'ordre de 50 µm pour la largeur des pistes conductrices aussi bien que pour la distance de séparation entre pistes.

La laque contenant du Pd, qui constitue un catalyseur et qui est déposée aux endroits adéquats à métalliser sur le support 1, est ensuite chauffée à 100°C. Puis une métallisation (cuivre ou nickel), par autocatalyse est effectuée, cette dernière opération étant depuis longtemps connue et maîtrisée : le cuivre (nickel) ne se dépose, sur le support 1, qu'aux endroits où du catalyseur est présent. L'épaisseur de cuivre déposé est comprise entre 1 et 10 µm. Le principal avantage de ce procédé électrochimique de métallisation est que plusieurs milliers à plusieurs dizaines de milliers de cartes peuvent être traitées en même temps, plongées ensemble dans un même bain, en l'espace de quelques heures.

Pour la deuxième étape de collage du circuit intégré au fond du logement, les colles utilisables ont déjà été indiquées plus haut.

Pour la troisième étape de réalisation des connexions électriques, le procédé de soudure de fil préféré est le procédé thermosonique utilisant du fil d'or de 25 ou 32 µm de diamètre. L'opération proprement dite doit s'effectuer à une température située entre 110 et 160°C, lorsque le support est en polycarbonate et de l'ordre de 110°C, s'il est en ABS. Le ramollissement du plastique doit être évité, avant la soudure, afin d'avoir un support stable, indispensable à l'établissement de connexions de bonne qualité. Ce ramollissement pourrait être consécutif au fait que, le plastique ayant une faible conductivité thermique, il est souhaitable de préchauffer le support avant la soudure effective. Il faut alors veiller à ce que la température communiquée au support ne dépasse pas la température de transition vitreuse Tg qui est de 120 à 140°C pour le polycarbonate et de 80 à 100°C pour l'ABS. Ensuite, un chauffage d'appoint par jet d'air chaud localisé sur le circuit intégré et les métallisations peut être effectué lors de l'indexage sur la position de soudure, ce qui permet d'atteindre la température voulue pendant un temps très bref, de l'ordre de 60 à 100 ms, au cours duquel le plastique n'a pas le temps de se ramollir significativement même si sa température de transition vitreuse est atteinte.

La dernière opération d'assemblage, c'est-à-dire la quatrième étape, consiste à remplir le logement 5 à l'aide d'une résine de très faible viscosité, typiquement 300 à 7000 mP.s, par un simple procédé dit de potting en anglais. La résine utilisée est de préférence une résine de haute pureté ionique, offrant une bonne résistance à l'absorption d'humidité et protégeant efficacement le circuit intégré lors des flexions et des torsions de la carte. Lorsqu'elle est polymérisée, la résine utilisée pour le potting doit avoir une certaine souplesse, sa dureté étant de 70 à 80 shore D. Plusieurs résines connues de l'homme de l'art conviennent, ces résines étant polymérisables soit par l'effet de la chaleur, soit par celui d'un rayonnement ultraviolet.

Pour la mise en oeuvre du procédé selon le deuxième mode de réalisation représenté aux figures 7 et 8 on notera que, lors de la deuxième étape, rien n'impose de coller le circuit intégré au centre du logement ni de disposer ses bords parallèlement aux plages métalliques. On peut en effet adopter une disposition non centrée et/ou non parallèle qui pourrait faciliter l'intercalement des fils conducteurs en évitant notamment d'avoir à les couder parallèlement au plan de la carte, ou encore si l'on souhaite éviter d'avoir trop à décaler les extrémités des pistes conductrices, par rapport à leur disposition très symétrique de l'art antérieur représenté à la figure 3. On notera aussi que le collage du circuit intégré peut s'effectuer au moyen d'une colle prépolymérisable par application d'un rayonnement ultraviolet, juste avant le collage : ce rayonnement active un catalyst qui déclenche à son tour la réaction de durcissement de la colle.

Lorsque le procédé de tampographie est utilisé, pour l'application des pistes conductrices, il est envisageable de réaliser par moulage des plaques comportant un assez grand nombre de supports de carte, d'effectuer la métallisation des plaques (première étape), puis de séparer les supports de carte par découpe de la plaque.

## Revendications

1. Procédé de production et d'assemblage de carte électronique comportant un support (1) de carte électriquement isolant muni d'un logement (5) pour recevoir un circuit intégré (4) dont tous les contacts sont ramenés d'un même côté du circuit intégré et, sur une face du support de carte, des plages métalliques (2) de contact reliées électriquement aux contacts dudit circuit intégré, les contacts dudit circuit intégré ayant une configuration inversée par rapport aux plages métalliques de contact auxquelles ils sont reliés, comportant les étapes suivantes :
- une première étape d'application, par une technologie MID signifiant Moulded Interconnection Devices en anglais, de pistes électriquement conductrices (15-20), toutes disposées contre le fond (7) et les parois latérales (6) dudit logement et reliées, chacune à l'une desdites plages métalliques de contact disposées sur la face du support qui comporte ledit logement,
- une deuxième étape de mise en place par collage au fond du logement dudit circuit intégré (4) par sa face qui ne comporte pas les contacts,
- une troisième étape de réalisation des connexions électriques par soudure de fils conducteurs (12) entre les contacts du circuit intégré et les extrémités des pistes conductrices correspondantes,
- une quatrième étape de remplissage dudit logement (5) avec une résine de protection (13) qui est ensuite polymérisée,
ledit procédé étant tel que, lors de la première étape, lesdites pistes conductrices (15, 20) parcourent tout le fond du logement où certaines desdites pistes conductrices (15, 16, 17) sont intercalées entre d'autres (18, 19, 20) desdites pistes conductrices, de façon que leurs extrémités soudées aux contacts du circuit intégré se situent selon une configuration inversée par rapport à celle des plages de contact auxquelles elles sont respectivement reliées et que, lors de la deuxième étape, ledit circuit intégré est collé au moyen d'une colle (21) non conductrice sur lesdites pistes.

2. Procédé de production et d'assemblage selon la revendication 1, **caractérisé en ce que**, entre la première et la deuxième étape, il comporte une étape supplémentaire consistant à compléter la configuration des pistes, au moins dans la zone où elles sont intercalées, au fond du logement, par une opération de gravure par faisceau laser, fixe ou mobile.

3. Procédé de production et d'assemblage de carte électronique comportant un support (1) de carte électriquement isolant muni d'un logement (5) pour recevoir un circuit intégré (4), les contacts dudit circuit intégré ayant une configuration inversée par rapport aux plages métalliques de contact auxquelles ils sont reliés et, sur une face dudit support de carte, des plages métalliques de contact reliées électriquement aux contacts dudit circuit intégré, comportant les étapes suivantes :
- une première étape d'application, par une technologie MID signifiant Moulded Interconnection Devices en anglais, de pistes électriquement conductrices (25- 30), toutes disposées contre le fond (7) et les parois latérales (6) dudit logement et reliées, chacune, à l'une desdites plages métalliques de contact disposées sur la face du support qui comporte ledit logement,
- une deuxième étape de mise en place par collage au fond du logement dudit circuit intégré (4) par sa face qui ne comporte pas les contacts,
- une troisième étape de réalisation des connexions électriques par soudure de fils conducteurs (12) entre les contacts du circuit intégré et les extrémités des pistes conductrices correspondantes,
- une quatrième étape de remplissage dudit logement (5) avec une résine. de protection (13) qui est ensuite polymérisée,
ledit procédé étant tel que, lors de la première étape, les extrémités desdites pistes sont disposées autour de l'emplacement dudit circuit intégré sur ledit fond du logement à des positions décalées dans un même sens de rotation par rapport aux plages de contact correspondantes et que, lors de la troisième étape certains desdits fils conducteurs (12), connectés entre des extrémités de pistes et des contacts correspondants dudit circuit intégré, s'étendent et s'intercalent au-dessus de la face du circuit intégré (4) qui porte lesdits contacts.

4. Procédé de production et d'assemblage selon la revendication 3, **caractérisé en ce que**, lors de la première étape, les extrémités des pistes conductrices sont disposées sur un palier intermédiaire (32) qui entoure ledit circuit intégré lors de la troisième étape.

5. Procédé de production et d'assemblage selon l'une des revendications 1 à 4, selon lequel la première étape d'application des pistes électriquement conductrices consiste en la découpe et le collage par pression à chaud des pistes munies d'une colle activable à chaud appelé hot foil embossing en anglais.

6. Procédé de production et d'assemblage selon l'une des revendications 1 à 4, selon lequel la première étape d'application des pistes électriquement conductrices consiste en l'application par tampographie d'un catalyseur, selon la configuration désirée pour les pistes, suivie d'une métallisation par autocatalyse.

## Claims

1. Process for production and assembly of an electronic board including an electrically insulating board support (1) provided with a housing (5) to receive an integrated circuit (4) all the contacts of which are taken to a same side of the integrated circuit and, on one face of the board support, metal contact fields (2) connected electrically to the contacts of the said integrated circuit, the contacts of the said integrated circuit having a reverse configuration relative to the metal contact fields to which they are connected, including the following steps:
- a first step of application, by an MID technology, signifying Moulded Interconnection Devices in English, of electrically conductive tracks (15 - 20), all arranged against the bottom (7) and the lateral walls (6) of the said housing and each connected to one of the said metal contact fields arranged on the face of the support which includes the said housing,
- a second step of placing in position by adhesion to the bottom of the housing of the said integrated circuit (4) by its face which does not include the contacts,
- a third step of forming the electrical connections by soldering conductive wires (12) between the contacts of the integrated circuit and the ends of the corresponding conductive tracks,
- a fourth step of filling the said housing (5) with a protective resin (13) which is then polymerised,
the said process being such that, at the first step, the said conductive tracks (15, 20) run around the whole bottom of the housing where certain of the said conductive tracks (15, 16, 17) are intercalated between others (18, 19, 20) of the said conductive tracks, so that their ends soldered to the contacts of the integrated circuit are situated in a reversed configuration relative to that of the contact fields to which they are respectively connected and that, at the second step, the said integrated circuit is adhered to the said tracks by means of a non-conductive adhesive (21).

2. Process for production and assembly as described in claim 1, **characterised by** the fact that, between the first and the second step, it includes an additional step consisting of finishing the configuration of the tracks, at least in the zone in which they are intercalated, at the bottom of the housing by an etching operation by a fixed or mobile laser beam.

3. Process for production and assembly of an electronic board including an electrically insulating board support (1) provided with a housing (5) to receive an integrated circuit (4), the contacts of the said integrated circuit having a reverse configuration relative to the metal contact fields to which they are connected and, on one face of the said board support, metal contact fields connected electrically to the contacts of the said integrated circuit, including the following steps:
- a first step of application, by an MID technology, signifying Moulded Interconnection Devices in English, of electrically conductive tracks (25 - 30), all arranged against the bottom (7) and the lateral walls (6) of the said housing and each connected to one of the said metal contact fields arranged on the face of the support which includes the said housing,
- a second step of placing in position by adhesion to the bottom of the housing of the said integrated circuit (4) by its face which does not include the contacts,
- a third step of forming the electrical connections by soldering conductive wires (12) between the contacts of the integrated circuit and the ends of the corresponding conductive tracks,
- a fourth step of filling the said housing (5) with a protective resin (13) which is then polymerised,
the said process being such that, at the first step, the ends of the said tracks are arranged around the location of the said integrated circuit on the said bottom of the housing in positions offset in a same direction of rotation relative to the corresponding contact fields and that, at the third step certain of the said conductive wires (12), connected between ends of tracks and corresponding contacts of the said integrated circuit, extend and are intercalated above the face of the integrated circuit (4) which carries the said contacts.

4. Process for production and assembly as described in claim 3, **characterised by** the fact that, at the first step, the ends of the conductive tracks are arranged on an intermediate level (32) which surrounds the said integrated circuit at the third step.

5. Process for production and assembly as described in one of claims 1 to 4, in accordance with which the first step of application of the electrically conductive tracks consists of cutting out and adhering by hot pressure tracks provided with a heat activatable adhesive called hot foil embossing in English.

6. Process for production and assembly as described in one of claims 1 to 4, in accordance with which the first step of application of the electrically conductive tracks consists of the application by tampography of a catalyst, in the configuration required for the tracks, followed by metallizing by autocatalysis.

## Patentansprüche

1. Anfertigungs- und Zusammenstellungsverfahren einer elektronischen Karte, umfassend einen elektrisch isolierenden Träger (1) der Karte, der mit einer Aufnahme bzw. einem Sitz bzw. einem Gehäuse (5) zur Aufnahme einer integrierten Schaltung (4), bei welcher sämtliche Kontakte von ein und derselben Seite der integrierten Schaltung zurückgeführt sind, und auf einer Seite des Trägers der Karte mit metallischen Kontaktbereichen (2) versehen ist, die elektrisch mit den Kontakten der integrierten Schaltung verbunden sind, welche Kontakte der integrierten Schaltung eine umgekehrte Konfiguration in bezug auf die metallischen Kontaktbereiche aufweisen, mit welchen sie verbunden sind, umfassend die folgenden Stufen bzw. Schritte:
- eine erste Stufe einer Aufbringung durch eine MID-Technologie, die auf englisch Moulded Interconnection Devices bedeutet, von elektrisch leitfähigen Bahnen (15 - 20), welche sämtliche am bzw. gegen Boden (7) und den Seitenwänden (6) des Sitzes angeordnet werden und jeweils mit einem der metallischen Kontaktbereiche verbunden werden, die auf der Seite bzw. Fläche des Trägers, welcher diesen Sitz umfaßt, angeordnet werden bzw. sind;
- eine zweite Stufe einer Anordnung durch Kleben am Boden des Sitzes der integrierten Schaltung (4) mittels ihrer Seite bzw. Fläche, die die Kontakte nicht umfaßt,
- eine dritte Stufe einer Ausführung von elektrischen Verbindungen durch Verschweißen bzw. Löten der leitfähigen Drähte (12) zwischen den Kontakten der integrierten Schaltung und den Enden bzw. Extrimitäten der entsprechenden leitfähigen Bahnen,
- eine vierte Stufe eines Auffüllens des Sitzes (5) mit einem Schutzharz (13), welches nachfolgend polymerisiert wird,
welches Verfahren derart ist, daß bei der ersten Stufe die leitfähigen Bahnen (15, 20) am Boden des Sitzes verlaufen, wo bestimmte dieser leitfähigen Bahnen (15, 16, 17) zwischen anderen (18, 19, 20) dieser leitfähigen Bahnen derart angeordnet werden, daß ihre an die Kontakte der integrierten Schaltung verschweißten bzw. gelöteten Enden sich entsprechend einer umgekehrten bzw. inversen Konfiguration in bezug auf jene der Kontaktbereiche, an welche sie jeweils angeschlossen bzw. mit welchen sie verbunden sind, angeordnet werden bzw. sind, und daß bei der zweiten Stufe diese integrierte Schaltung mittels eines nicht leitfähigen Klebers (21) auf diese Bahnen geklebt wird.

2. Anfertigungs- und Zusammenstellungsverfahren nach Anspruch 1, **dadurch gekennzeichnet, daß** es zwischen der ersten und der zweiten Stufe eine zusätzliche Stufe umfaßt, bestehend aus einem Komplettieren der Konfiguration der Bahnen wenigstens in dem Bereich, wo sie am Boden des Sitzes verschachtelt bzw. zwischen einander angeordnet werden bzw. sind, durch ein Gravurverfahren mittels feststehendem oder mobilem Laser bzw. Laserstrahl.

3. Anfertigungs- und Zusammenstellungsverfahren einer elektronischen Karte, umfassend einen elektrisch isolierenden Kartenträger (1), der mit einer Aufnahme bzw. einem Sitz (5) zum Aufnehmen einer integrierten Schaltung (4) versehen ist, wobei die Kontakte der integrierten Schaltung eine umgekehrte bzw. inverse Konfiguration in bezug auf metallische Kontaktbahnen, an welche sie angeschlossen sind, und auf einer Seite des Kartenträgers die metallischen Kontaktbereiche aufweisen, die elektrisch an die Kontakte der integrierten Schaltung angeschlossen sind, umfassend die folgenden Stufen bzw. Schritte:
- eine erste Stufe eines Aufbringens durch eine MID-Technologie, die auf englisch Moulded Interconnection Devices bedeutet, von elektrisch leitfähigen Bahnen (25 - 30), die jeweils am bzw. gegen Boden (7) und den Seitenwänden (6) des Sitzes bzw. Gehäuses angeordnet sind und sämtliche mit einem der metallischen Kontaktbereiche verbunden werden, die auf der Seite des Trägers, welcher diesen Sitz umfaßt, angeordnet werden bzw. sind;
- eine zweite Stufe einer Anordnung durch Kleben am Boden des Sitzes der integrierten Schaltung (4) mittels ihrer Seite bzw. Fläche, die die Kontakte nicht umfaßt,
- eine dritte Stufe einer Ausführung von elektrischen Verbindungen durch Verschweißen bzw. Verlöten der leitfähigen Drähte (12) zwischen den Kontakten der integrierten Schaltung und den Enden der entsprechenden leitfähigen Bahnen,
- eine vierte Stufe eines Auffüllens des Sitzes (5) mit einem Schutzharz (13), welches nachfolgend polymerisiert wird,
welches Verfahren derart ist, daß bei der ersten Stufe die Enden der Bahnen um den Platz der integrierten Schaltung am Boden des Sitzes in abgesetzten bzw. verschobenen Positionen in einer selben Dreh- bzw. Schwenkrichtung in bezug auf die entsprechenden Kontaktbereiche angeordnet werden und daß bei der dritten Stufe bestimmte der leitfähigen Drähte (12), die zwischen den Enden der Bahnen und den entsprechenden Kontakten der integrierten Schaltung angeschlossen werden, sich über die Seite bzw. Fläche der integrierten Schaltung (4), welche diese Kontakte trägt, erstrecken und verschachtelt bzw. zwischengelegt werden.

4. Anfertigungs- und Zusammenstellungsverfahren nach Anspruch 3, **dadurch gekennzeichnet, daß** bei der ersten Stufe die Enden der Leiterbahnen auf einem Zwischenpodest bzw. -stufe bzw. -schulter (32) angeordnet werden, welches die integrierte Schaltung bei der dritten Stufe umgibt.

5. Anfertigungs- und Zusammenstellungsverfahren nach einem der Ansprüche 1 bis 4, gemäß welchem die erste Stufe des Aufbringens der elektrisch leitfähigen Bahnen in dem Stanzen und dem Kleben durch Heißpressen der mit einem heiß aktivierbaren Kleber versehenen Bahnen, was auf englisch "hot foil embossing" genannt wird, durchgeführt wird.

6. Anfertigungs- und Zusammenstellungsverfahren nach einem der Ansprüche 1 bis 4, gemäß welchem die erste Stufe des Aufbringens der elektrisch leitfähigen Bahnen in dem Aufbringen eines Katalysators durch Tampografie gemäß der gewünschten Konfiguration der Bahnen, gefolgt von einer Metallisierung durch Autokatalyse, besteht.
